# EUROPÄISCHE PATENTSCHRIFT

(11) **EP 1 673 841 B1**
(45) Veröffentlichungstag und Bekanntmachung des Hinweises auf die Patenterteilung: **19.09.2007**
(21) Anmeldenummer: 04761889.7
(22) Anmeldetag: 31.08.2004
(51) Int. Cl.: H02G 3/06, H02G 3/22, H05K 9/00, H02G 15/04

(54) **EMV-DICHTE HALTEVORRICHTUNG FÜR KABEL**
HOLDING DEVICE FOR CABLES, COMPRISING AN EMC SEAL
DISPOSITIF DE FIXATION A PROTECTION CEM DESTINE A UN CABLE

(30) Priorität: 30.09.2003 CH 166103
(43) Veröffentlichungstag der Anmeldung: 28.06.2006
(73) Patentinhaber: Stünzi Industrieelektronik GmbH, 8806 Bäch (CH)
(72) Erfinder: STÜNZI, Edwin, CH-8806 Bäch (CH)
(74) Vertreter: Frei Patent Attorneys
(86) Internationale Anmeldenummer: PCT/CH2004/000549
(87) Internationale Veröffentlichungsnummer: WO 2005/031935

(56) Entgegenhaltungen:
- DE-A- 19 731 448
- GB-A- 1 402 861
- SE-C- 131 239
- US-A- 4 547 623
- US-A- 5 237 129
- US-B1- 6 354 851
- "Das große Wörterbuch der deutschen Sprache in sechs Bänden" 1977, DUDEN , MANNHEIM/WIEN/ZÜRICH, DUDENVERLAG * Seite 645 *

## Beschreibung

Die Erfindung liegt auf dem Gebiet der Anschlusstechnik bzw. der Installationstechnik sowie der elektromagnetischen Verträglichkeit (EMV). Sie betrifft eine Haltevorrichtung, eine Anordnung einer solchen Haltevorrichtung und mindestens eines in der Haltevorrichtung gehaltenen Kabels, ein Verfahren zum Aufbau der Haltevorrichtung und ein Verfahren zum Demontieren einer solchen Anordnung, gemäss den Oberbegriffen der unabhängigen Patentansprüche.

In vielen Bereichen der Technik müssen Verbindungen und Anschlüsse in Form von Kabeln durch Wandungen durchgeführt und gleichzeitig befestigt werden, so z. B. Kabel für Energie, Aktoren, Sensoren, Sonden für Temperatur und Druck und/oder Lichtleiter durch Wandungen von Anschlussdosen in der Automationstechnik. Dabei wird in den meisten Anwendungen eine zuverlässige mechanische Kabelzugentlastung und eine Abdichtung gegen Staub und Wasser gefordert. Solche Vorrichtungen zur Befestigung von Kabeln bei deren Durchführung durch eine Wandung sind bekannt, bspw. aus der Schrift DE-197'31'44.8, welche durch Verweis in die vorliegende Schrift aufgenommen wird.

Zusätzlich ist bei Kabelbefestigungsvorrichtungen oft eine Abdichtwirkung gegenüber elektromagnetischer Ein- und Ausstrahlung (EMV-Dichtung) erwünscht. Zu diesem Zweck werden bspw. Kabelabfangleisten mit Ableitblechen verwendet um die Leitungsschirmung direkt mit dem Erdungspotential zu verbinden. Diese Lösung hat den Nachteil, dass die EMV-Abdichtung nicht in genügendem Masse erreicht wird.

Eine andere bekannte Lösung zur Erreichung der EMV-Dichtung besteht im Einsatz leitfähiger Elastomere. Diese Lösung hat den Nachteil, dass die Kabelbefestigungsvorrichtungen sehr präzise ausgearbeitet werden müssen, um eine gute EMV-Dichtung zu gewährleisten; somit bleibt kein Spielraum für verschiedene oder wenigstens leicht abweichende Kabeldurchmesser.

Eine andere bekannte Lösung sind Kabelverschraubungen (Stopfbuchsen), wobei z. B. aus Hülsen geschlitzte rohrähnlich angeordnete Federfinger über Schraubgewinde an das Schirmgeflecht gepresst werden. Bei einer anderen Art von Kabelverschraubungen wird das freigelegte Abschirmgeflecht zwischen zwei konusförmigen Scheiben festgeklemmt. Im US-Patent Nr. 4,547,623 wird eine Stopfbuchse vorgeschlagen, in welcher Metallringe den elektrischen Kontakt zum Kabelschirm herstellen. In den US-Patenten Nm. 6,354,851, worin eine Haltevorrichtung gemäß dem Oberbegriff des Anspruchs 1 beschrieben ist, und 5,237,129 sind Kabelverschraubungen mit Endlos-Federringen offenbart, welche mittels eines Schraubverschlusses zusammengedrückt werden und auf diese Weise eine Kontaktierung zum Kabelschirm erreichen. Mit solchen Stopfbuchsen kann eine mässige bis gute EMV-Dichtung erreicht werden. In allen erwähnten Beispielen wird für die Anordnung der Installation relativ viel Platz benötigt. Wegen des komplizierten Aufbaus mit vielen Einzelteilen und der Verschraubung erfordert die Installation von Stopfbuchsen viel Zeit. Für die Installation von Stopfbuchsen werden in allen Fällen Werkzeuge, teilweise sogar Spezialwerkzeuge, benötigt.

Es ist eine Aufgabe der Erfindung, eine EMV-dichte Haltevorrichtung der oben beschriebenen Art für Kabel zu schaffen, in welcher Kabel schnell, werkzeugfrei und in platzsparender Anordnung befestigt werden können. Ferner ist es Aufgabe der Erfindung, eine Anordnung einer solchen Haltevorrichtung und eines in der Haltevorrichtung gehaltenen Kabels zu schaffen. Weitere Aufgaben der Erfindung sind, ein Verfahren zum Aufbau und ein Verfahren zum Demontieren einer solchen Anordnung anzugeben. Die und andere Aufgaben werden gelöst durch die Haltevorrichtung, die Anordnung und die Verfahren, wie sie in den unabhängigen Patentansprüchen definiert sind. Vorteilhafte Ausführungsformen sind in den abhängigen Patentansprüchen angegeben.

Der Erfindung liegt die Idee zugrunde, Kontaktierungsmittel bereitzustellen, mittels welcher sowohl ein elektrischer Kontakt als auch eine mechanische Einrastverbindung zwischen der Kabelabschirmung und Durchführmitteln, durch welche das Kabel durchgeführt ist, herstellbar ist. Dadurch, dass diese Kontaktierungsmittel beide Aufgaben gleichzeitig erfüllen, wird der Aufbau der erfindungsgemässen Vorrichtung einfach und platzsparend.

Die mechanische Einrastverbindung ist schnell und auf einfachste Art und Weise aufbaubar sowie wieder demontierbar, und zwar gänzlich ohne Werkzeuge. Sie kann z. B. durch Einrasten oder Einschnappen einer Ringfeder in einer ringförmigen Nut oder durch rätschenartiges Einrasten einer Ringfeder in Abstufungen einer konischen Innenwand hergestellt werden. Eine solche Einrastverbindung ist immer zumindest teilweise formschlüssig, kann aber, wie im Fall der Rätsche, auch eine kraftschlüssige Komponente beinhalten.

Die erfindungsgemässe Haltevorrichtung dient zur befestigten, zugentlasteten und elektromagnetisch abgedichteten Halterung eines elektromagnetische Abschirmmittel enthaltenden, eine Kabelachse definierenden Kabels. Sie beinhaltet Durchführmittel mit einer Durchführöffnung zur Durchführung des Kabels, welche Durchführöffnung eine elektrisch leitende Innenfläche aufweist, und Kontaktierungsmittel zur Herstellung eines elektrischen Kontaktes zwischen den elektromagnetischen Abschirmmitteln und der Innenfläche der Durchführmittel. Die Kontaktierungsmittel sind in radialer Richtung bezüglich der Kabelachse elastisch verformbar und geeignet, eine mechanische Einrastverbindung zwischen dem Kabel und den Durchführmitteln herzustellen.

Bei der erfindungsgemässen Anordnung einer erfindungsgemässen Haltevorrichtung und mindestens eines in der Haltevorrichtung gehaltenen Kabels, welches Kabel einen elektrisch isolierenden Mantel aufweist, ist im Bereich der Haltevorrichtung eine bis zu den elektromagnetischen Abschirmmitteln reichende ringförmige Nut aus dem Mantel herausgeformt. Die Kontaktierungsmittel wirken mit der Nut zusammen, um die mechanische Einrastverbindung zwischen dem Kabel und den Durchführmitteln herzustellen.

Das erfindungsgemässe Verfahren zum Aufbau einer erfindungsgemässen Anordnung beinhaltet die folgenden Verfahrensschritte:
(a) Herausformen einer bis zu den elektromagnetischen Abschirmmitteln reichenden ringförmigen Nut aus dem Mantel des Kabels;
(b) Durchführen des Kabels durch die Durchführöffnung der Durchführmittel;
(c) Aufbringen der Kontaktierungsmittel auf die ringförmige Nut des Kabels, derart, dass die Kontaktierungsmittel mit den elektromagnetischen Abschirmmitteln des Kabels elektrisch kontaktiert sind;
(d) Herstellen eines elektrischen Kontaktes zwischen den elektromagnetischen Abschirmmitteln und den Durchführinitteln sowie einer mechanischen Einrastverbindung zwischen dem Kabel und den Durchführmitteln mittels der Kontaktierungsmittel, indem das Kabel relativ zu den Durchführmitteln in Richtung der Kabelachse bewegt wird.

Das erfindungsgemässe Verfahren zum Demontieren einer erfindungsgemässen Anordnung beinhaltet die folgenden Verfahrensschritte:
(a) Lösen der mechanischen Einrastverbindung, indem eine Mehrkraft in Richtung der Kabelachse auf das Kabel ausgeübt wird;
(b) Bewegen des Kabels relativ zu den Durchführmitteln in Richtung der Kabelachse, bis sich die Kontaktierungsmittel ausserhalb der Durchführmittel befinden;
(c) Entfernen der Kontaktierungsmittel von der ringförmigen Nut;
(d) Entfernen des Kabels von den Durchführmitteln.

Im Folgenden werden bevorzugte Ausführungsformen der Erfindung anhand der Figuren detailliert erläutert. Dabei zeigen:
- Fig. 1: Durchführmittel einer erfindungsgemässen Haltevorrichtung in einem Längsschnitt;
- Fig. 2-4: eine erfindungsgemässe Haltevorrichtung in einem Längsschnitt, einer Frontalansicht bzw. einer aufgeschnittenen perspektivischen Ansicht;
- Fig. 5-9: den Aufbau einer erfindungsgemässen Haltevorrichtung in fünf zeitlich aufeinanderfolgenden Schritten, in einem Längsschnitt;
- Fig. 10: eine erfindungsgemässe Haltevorrichtung in einer teilweise aufgeschnittenen perspektivischen Ansicht;
- Fig. 11 (a)-(c): drei Ausführungsformen von möglichen Kontaktierungsmitteln im Querschnitt;
- Fig. 12: eine weitere Ausführungsform der erfindungsgemässen Haltevorrichtung in derselben Ansicht wie Fig. 10;
- Fig. 13 und 14: zwei Ausführungsformen von Anordnungen von erfindungsgemässen Haltevorrichtungen in teilweise aufgeschnittenen perspektivischen Explosionsansichten.

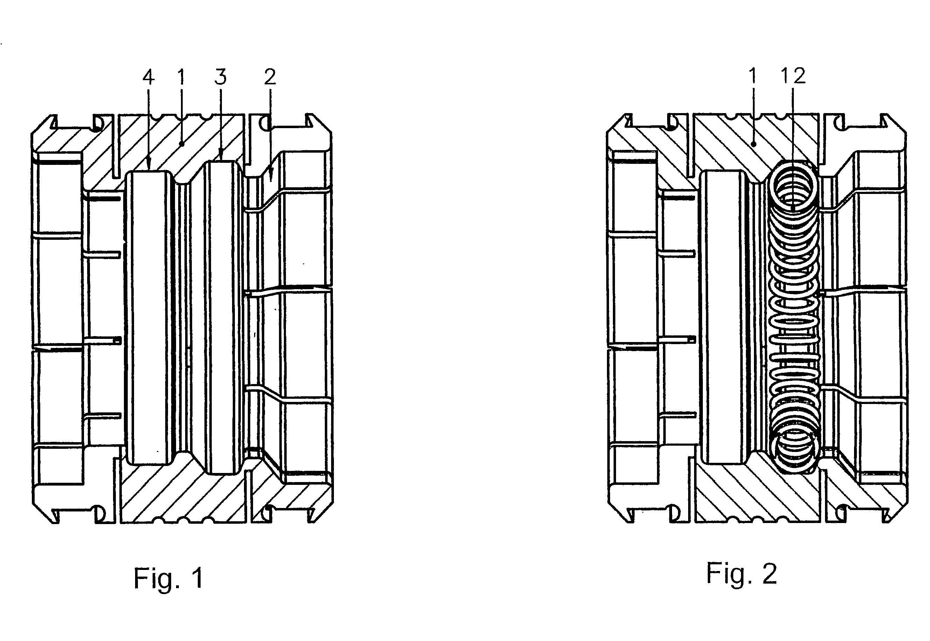

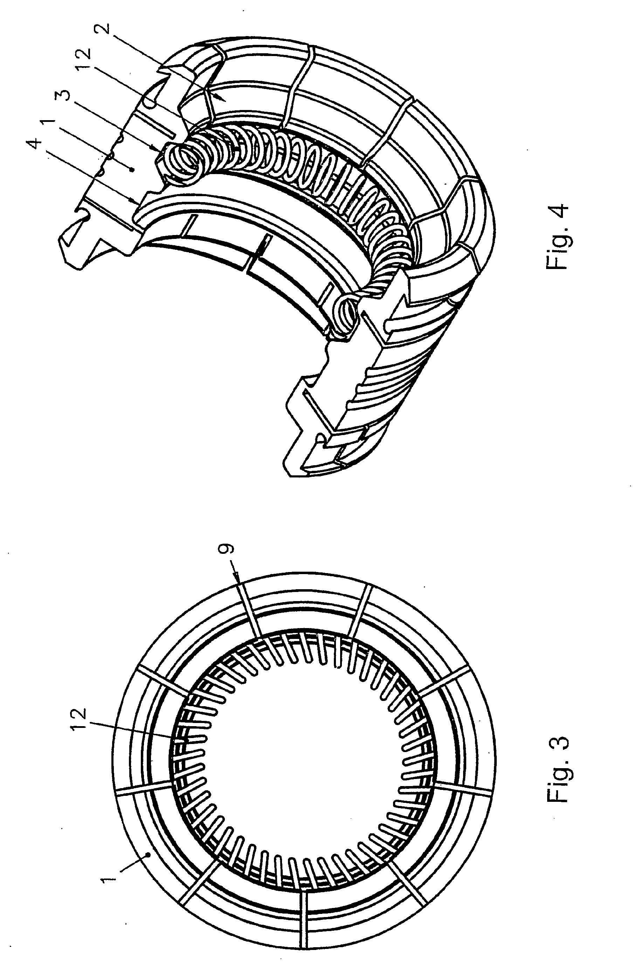

**Figuren 1 und 2-4** zeigen eine beispielhafte Ausführungsform einer erfindungsgemässen Haltevorrichtung bzw. von Teilen davon.

Die Haltevorrichtung dient dazu, ein (nicht eingezeichnetes) Kabel mit elektromagnetischen Abschirmmitteln, bspw. ein Steuer-Rundkabel mit einem Mantel und einem Schirmgeflecht, zu haltern, wobei die Halterung befestigt, zugentlastet und elektromagnetisch abgedichtet sein soll. Aus dem Mantel ist vorzugsweise eine bis zum Schirmgeflecht reichende ringförmige Nut herausgeformt, bspw. herausgeschnitten. Die Haltevorrichtung beinhaltet Durchführmittel mit einer Durchführöffnung zur Durchführung des Kabels, welche Durchführmittel elektrisch leitend ausgebildet sind. Diese Durchführmittel sind im Ausführungsbeispiel von Fig. 1-4 als vorzugsweise zylindrische Kontakthülse 1 ausgebildet, deren Innenfläche mindestens eine ringförmige Nut 3, 4 aufweist. Die Hülse 1 kann in einer Wandung, durch welche das Kabel durchzuführen ist, befestigt sein. Als Hülsenmaterial eignen sich Materialien aus speziellen Metalllegierungen, bspw. Chromstahllegierungen, oder spezielle Kunststoffinischungen, bspw. Pitchgranulate, welche mit leitfähigen Stoffen durchmischt sind, vorzugsweise wie Chromstahl, Zink, Beryllium, Kupfer, um nur einige bevorzugte EMV-Materialien zu nennen. Die Hülse 1 kann einstückig oder mehrstückig hergestellt sein. Im letzteren Fall kann sie aus bspw. zwei Halbschalen zusammengesetzt sein, welche durch geeignete Verbindungsmittel, bspw. eine Schnappverbindung, miteinander verbunden sind. Derartige Halbschalen lassen sich in der Regel einfacher und kostengünstiger herstellen als einstückige Hülsen, bspw. mittels Pressen oder Giessen.

Speziell geformte Nuten 3, 4 dienen der Aufnahme und der Positionierung von Kontaktierungsmitteln 12 zur Herstellung eines elektrischen Kontaktes zwischen dem Schirmgeflecht und der Kontakthülse 1. Diese Kontaktierungsmittel 12 sind als (in den Figuren nur schematisch eingezeichnete) Ringfedern mit schräger Wicklung und konstantem linearem Druckprofil aus Metall, bspw. Edelstahl oder Beryllium/Kupfer, ausgebildet. Solche Federn 12 werden bspw. im Katalog Nr. DM8 "BalShield" der Firma Bal Seal Engineering Europe BV, Amsterdam, angeboten. Die Feder 12 ist in radialer Richtung bezüglich einer Kabelachse elastisch verformbar und stellt eine mechanische Einrastverbindung zwischen dem Kabel und der Hülse 1 her. Ein Ende der Hülse 1 ist vorzugsweise mit einem Kragen 2 ausgestattet, um die Einführung der Feder 12 zu erleichtern. Im hier diskutierten Ausführungsbeispiel weist die Hülse 1 zwei Nuten 3, 4 mit unterschiedlichen Tiefen auf, damit dieselbe Hülse 1 mit nur einer Feder 12 für eine viel grössere Bandbreite von Kabeldurchmessern verwendet werden kann, bzw. damit verschiedene Kontaktierungsdrücke individueller angewendet werden können. Zusammengefasst stellt die Feder 12 einerseits eine zugentlastete, mechanische Verbindung zwischen der Hülse 1 und dem Kabel und andererseits einen elektrischen Kontakt zwischen der Hülse 1 und dem Schirmgeflecht und somit, dank der hohen Verdichtung der radial zusammengepressten Feder, eine sehr gute EMV-Dichtung dar.

Die erfindungsgemässe Haltevorrichtung kann ferner mit einem Flanschelement, welches eine oder mehrere Öffnungen aufweist, durch welche ein oder mehrere Kabel durchführbar ist bzw. sind, kombiniert werden. Die Durchführöffnungen können verschiedene Durchmesser zur Aufnahme von Hülsen bzw. Kabeln mit verschiedenen Durchmessern haben. Die Hülse kann auf dem Flanschelement befestigt oder aus diesem herausgeformt sein, oder kann in einem Flanschgehäuse spritztechnisch integriert sein. Das Flanschelement liegt vorzugsweise in einer zur Kabelachse senkrechten Ebene und ist vorzugsweise als Sandwichkonstruktion aus mehreren, vorzugsweise in einem Flanschgehäuse eingebetteten Platten aufgebaut, wie in der Schrift DE-197'31'448 offenbart.

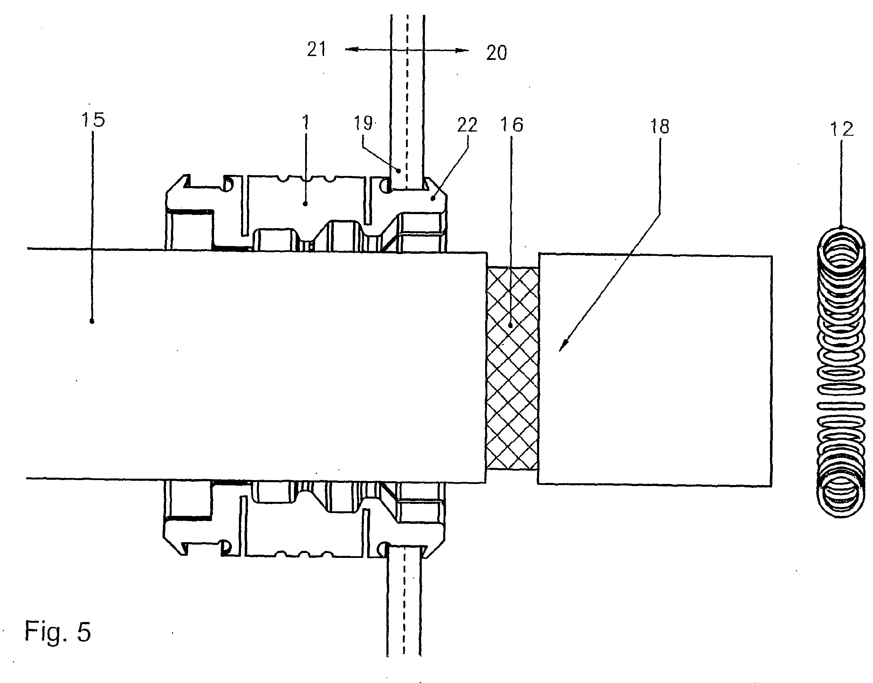

Im Folgenden wird ein bevorzugtes erfindungsgemässes Verfahren für den Aufbau einer erfindungsgemässen Anordnung einer erfindungsgemässen Haltevorrichtung und eines in der Haltevorrichtung gehaltenen Kabels beschrieben. Figuren 5-9 illustrieren fünf zeitlich aufeinanderfolgende Schritte des Verfahrens. Ein grosser Vorteil dieser Erfindung besteht darin, dass auf einfachste Art mit werkzeugfreier Montage sehr gute EMV-Abschirmungen erreicht werden. Weitere Vorteile nebst platzsparender, kompakter Anordnung sind das schnelle Aufbauen, das schnelle Demontieren und die Wiederverwendbarkeit des Kontaktierungsmittels 12 nach dem Demontieren der Anordnung.

**Figur 5:** Zuerst wird eine Hülse 1 als Durchführungsmittel von einem Aussenhalbraum 21 her mittels eines Schnappverschlusses 22 in eine Wandung 19 eingeschnappt. Nun wird ein Kabel 15 vom Aussenhalbraum 21 her durch die Hülse 1 und die Wandung 19 (oder ein Flanschelement) durchgeführt. Danach wird das Kabel 15 im Bereich eines Innenhalbraums 20 mit einem Doppelschnitt bis auf ein Schirmgeflecht 16 eingeschnitten, und die Kabelummantelung wird zwischen den Schnittstellen entfernt. Eine so im Kabelmantel 17 entstandene Abmantelungsstelle 18 sollte etwas breiter sein als der Durchmesser einer zu verwendenden EMV-Kontaktfeder 12. Messer für die Ausführung eines Schirmlitzen-schonenden Doppelschnittes sind auf dem Markt, z. B. von der Firma Siemens, erhältlich, bspw. als Koaxialkabelmesser oder als Buskabel-Messer mit Doppelschneiden, welche im Tiefenschnitt eingestellt werden können.

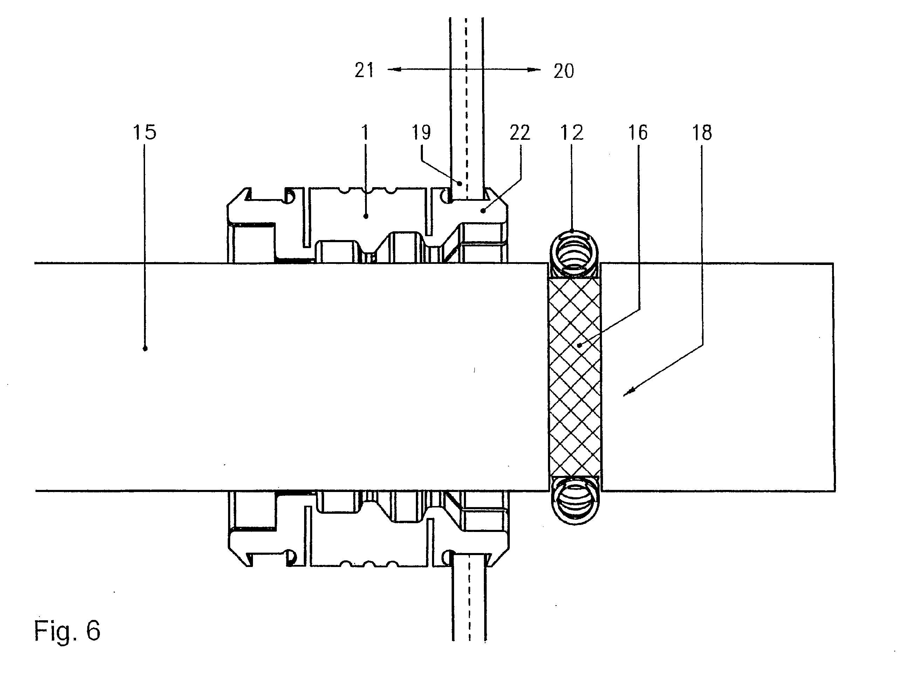

**Figur 6:** In diesem Schritt wird eine Ringfeder 12 vom Innenhalbraum 20 her über das Kabel 15 gestülpt. Sie ist derart auf den Kabeldurchmesser abgestimmt, dass sie in radialer Richtung vorgespannt ist, wenn sie das bis zum Schirmgeflecht 16 abgemantelte Kabel 15 umfasst. Die Feder 12 wird nun zur Abmantelungsstelle 18 gerollt, geschoben oder gestossen und rastet bei dieser ein. Wegen der genannten Vorspannung übt sie in der eingerasteten Position radiale Druckkräfte zur Kabelachse hin auf das Schirmgeflecht 16 aus.

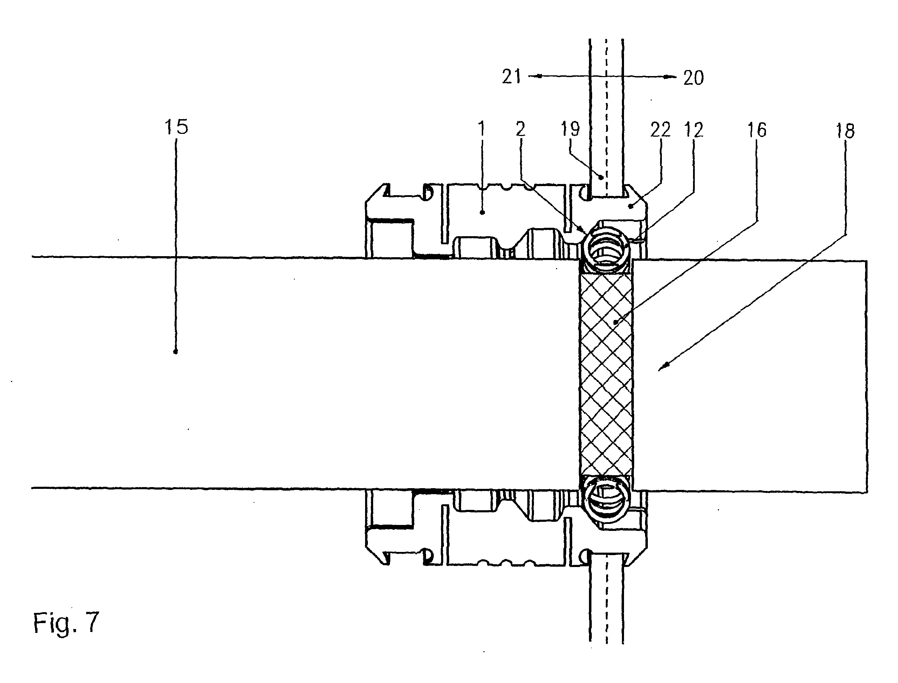

**Figur 7:** Durch Ausüben einer erhöhten, jedoch gleichmässigen Zugkraft vom Aussenhalbraum 21 her, bzw. einer Stosskraft vom Innenhalbraum 20 her, auf das Kabel 15 wird das Kabel 15 zur Hülse 1 zurück bewegt, bis die Feder 12 die Hülse 1 berührt.

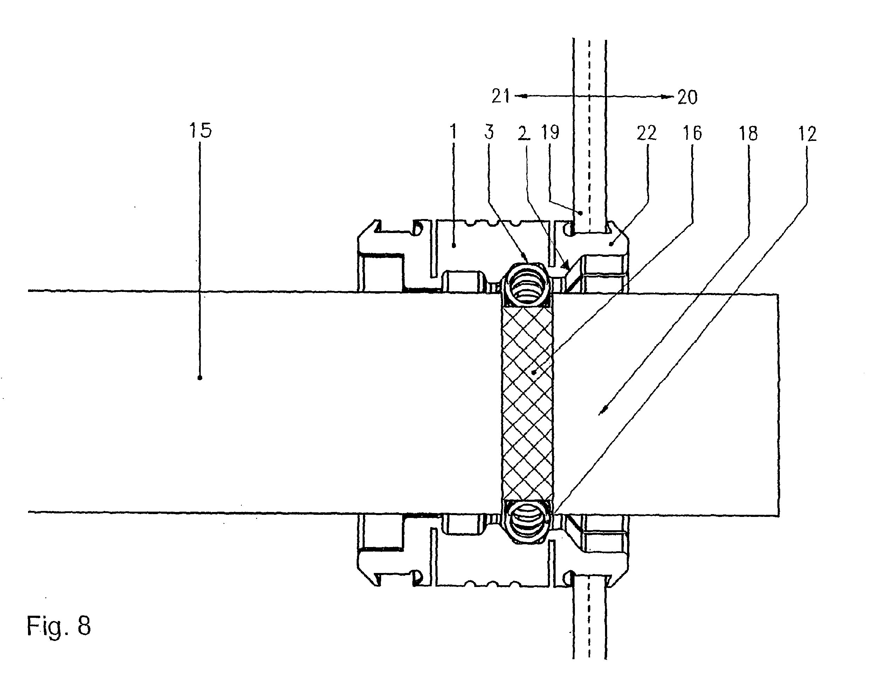

**Figur 8:** Nun, durch Erhöhung der Zug- bzw. Stosskraft auf das Kabel 15, wird die schräg gewickelte Feder 12 flachgelegt und rutscht am Kabelschirm 16 haltend mit in die Hülse 1. Das dem. Innenhalbraum 20 zugewandte Ende der Hülse 1 ist vorzugsweise mit einem Aufnahmekragen 2 ausgestattet, um die Einführung der Feder 12 zu erleichtern. Eine solche Feder 12 kann um bis zu 50 % ihres Windungsdurchmessers zusammengedrückt werden, wobei das Federdruckprofil unabhängig vom Kabeldurchmesser annähernd gleich bleibt. Durch das Flachlegen verringert sich der Aussendurchmesser der Feder 12, und sie schlüpft in die Hülse 1 hinein. Das Einführen der Feder 12 in die Hülse 1 wird unter Kraftanwendung so lange fortgesetzt, bis die Feder 12 spürbar in einer ersten Nut 3 auf der Innenfläche der Hülse 1 einrastet. In einer bevorzugten Ausführungsform weist die Hülse 1 mehrere, bspw. zwei bis drei, Nuten unterschiedlicher Tiefe auf, wobei die Tiefe der Nuten in Einzugsrichtung des Kabels, also gegen den Aussenhalbraum 21 hin, abnimmt. Die unterschiedlich tiefen Nuten geben eine Auswahlmöglichkeit für die Krafteinstellung der Rückzugentlastungskräfte und des optimalen Kontaktierungsdruckes auf das Schirmgeflecht 16, respektive erlauben, eine grössere Kabeldurchmesser-Bandbreite in ein und derselben Durchführung applizieren zu können.

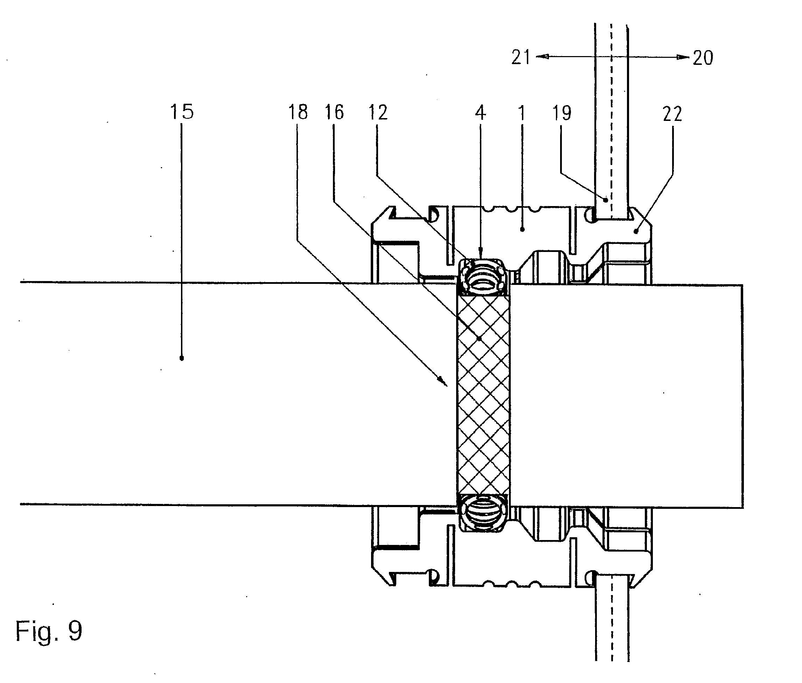

**Figur 9** zeigt schliesslich die in einer zweiten Nut 4 eingerastete Feder 12. Diese zweite Nut 4 hat einen kleineren Durchmesser als die erste Nut 3, wodurch sich die Feder 12 auf kleinere Kabeldurchmesser anpasst, da sie in der zweiten Nut 4 in stärkerem Masse zusammengedrückt bzw. flachgelegt wird.

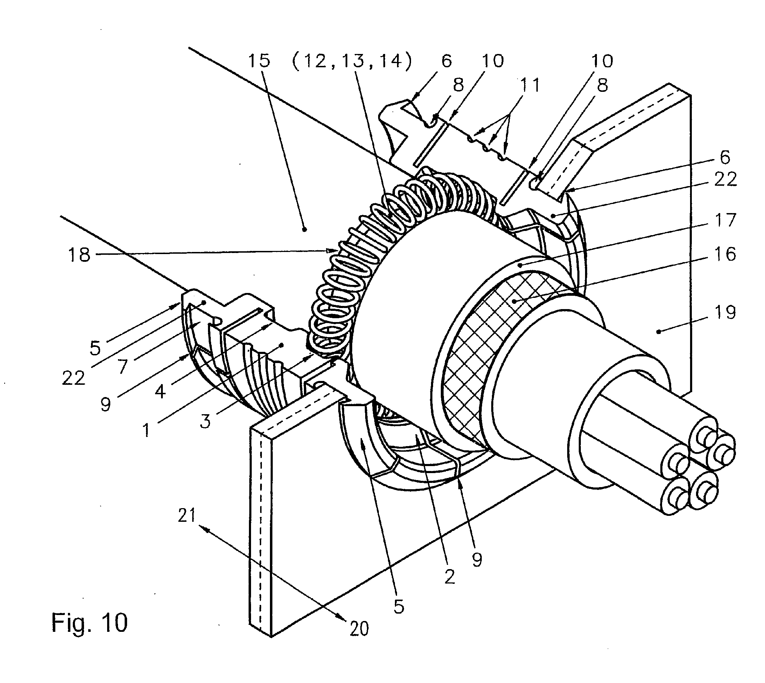

**Figur 10** zeigt eine erfindungsgemässe Anordnung in einer teilweise aufgeschnittenen perspektivischen Ansicht. Die Hülse 1 ist vorzugsweise in einer Wandung 19 befestigt, bspw. mittels eines Schnappverschlusses 22. Die äussere Fläche des Schnappverschlusses 22 weist eine Nase 6 und eine O-Ring Nut 8 auf, welche bei der Montage in die Wandung einrasten. Die radiale Beweglichkeit des Schnappverschlusses 22, welche für die Montage und Demontage der Schnappverbindung nötig ist, wird durch axiale Federungsschlitze 9 und radiale Federungsschlitze 10 erleichtert. Statt eines Schnappverschlusses 22 kann die Befestigung der Hülse 1 in der Wandung 19 mittels sonstiger möglicher Befestigungsmittel erfolgen, bspw. mittels verzahnter Presssitzrillen oder mittels eines Gewindes in einem Flanschelement. In einer anderen Ausführungsform (vgl.

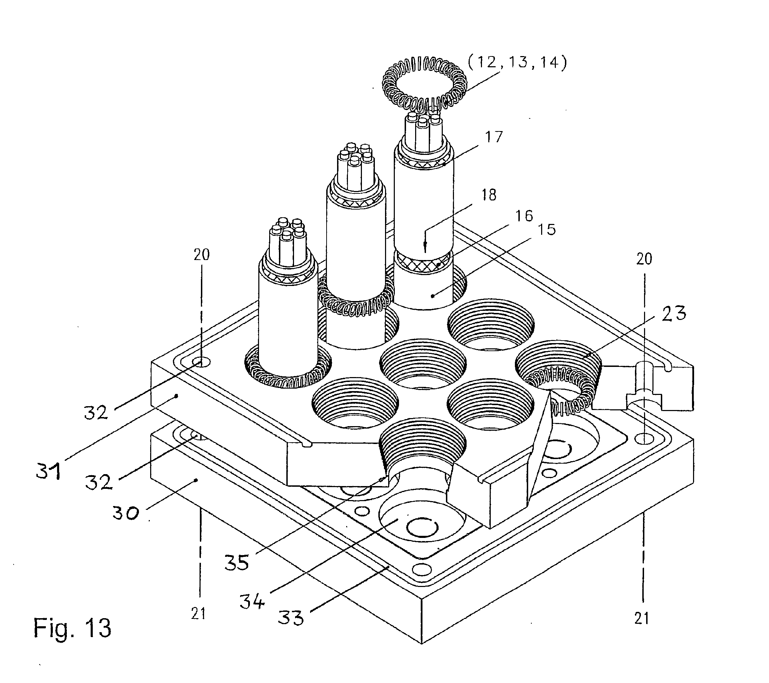

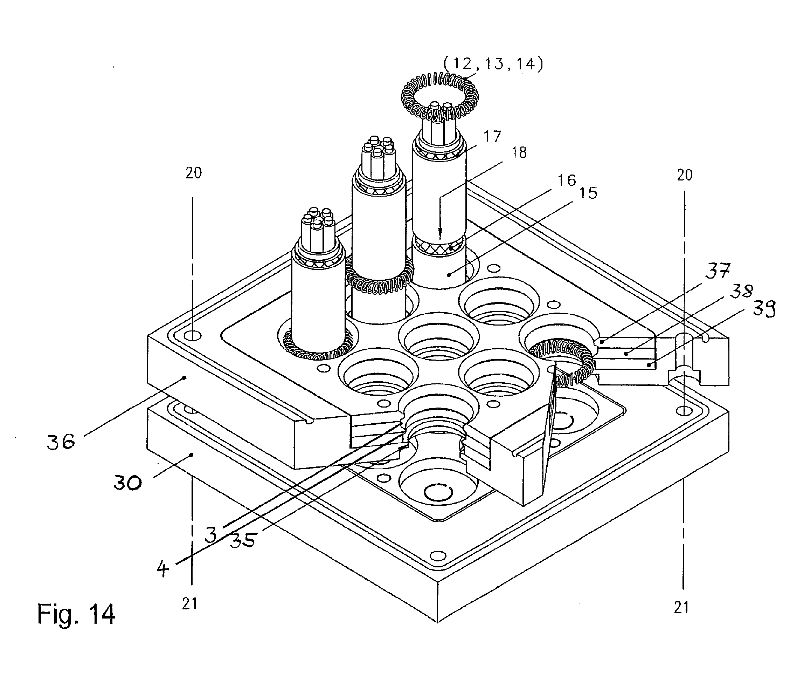

Fig. 13, 14) kann die Hülse 1 auch integrierter Bestandteil eines Flanschgehäuses sein.

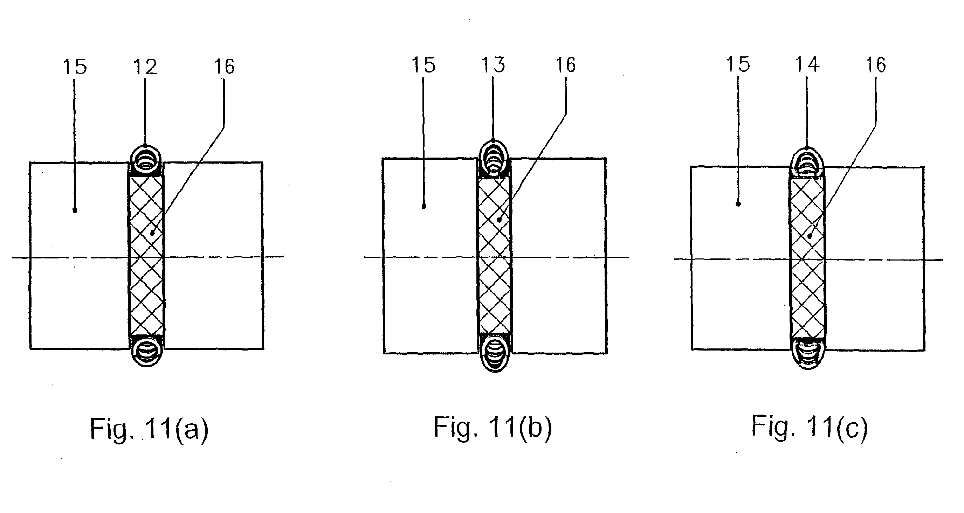

Drei Ausführungsformen von Ringfedern 12, 13 bzw. 14, welche sich besonders für die erfindungsgemässe Haltevorrichtung eignen, sind in Figuren 11(a)-11(c) zusammen mit einem Teil des Kabels 15 im Querschnitt dargestellt. Die Feder 12 von **Figur 11(a)** hat einen kreisförmigen Querschnitt, die Feder 13 von **Figur 11(b)** einen elliptischen Querschnitt, wobei die elliptische Feder 13 aus Gründen der Energieminimierung im Normalfall eine Stellung einnehmen wird, in welcher die kurze Achse der Ellipse parallel zur Kabelachse liegt. **Figur 11(c)** zeigt eine Feder 14 mit annähernd halbkreisförmigem Querschnitt. Die gerade Seite des den Halbkreis begrenzenden Durchmessers liegt auf dem Schirmgeflecht 16 auf, wodurch eine sehr gute Fixierung und Kontaktierung der Feder 14 auf dem Schirmgeflecht 16 erreicht wird.

Im Folgenden wird ein bevorzugtes erfindungsgemässes Verfahren für das Demontieren der erfindungsgemässen Anordnung beschrieben. Für die Demontage werden, analog zum Aufbau, auch keine Werkzeuge benötigt. Das Kabel 15 mit der am Schirmgeflecht 16 haftenden Feder 12, 13, 14 wird mit Mehrkraft in Richtung Innenhalbraum 20 gezogen bzw. gestossen, so dass die Feder 12, 13, 14 von Hand greifbar wird und aus der Nut der Abmantelungsstelle 18 des Kabels 15 durch Zurückrollen, Zurückschieben oder Zurückstossen entfernt werden kann. Anschliessend kann das Kabel 15 Richtung Aussenraum 21 zurückgezogen werden. Dank der werkzeugfreien Demontage der Anordnung kann die Kontaktierungsfeder 12, 13, 14 wiederverwendet werden.

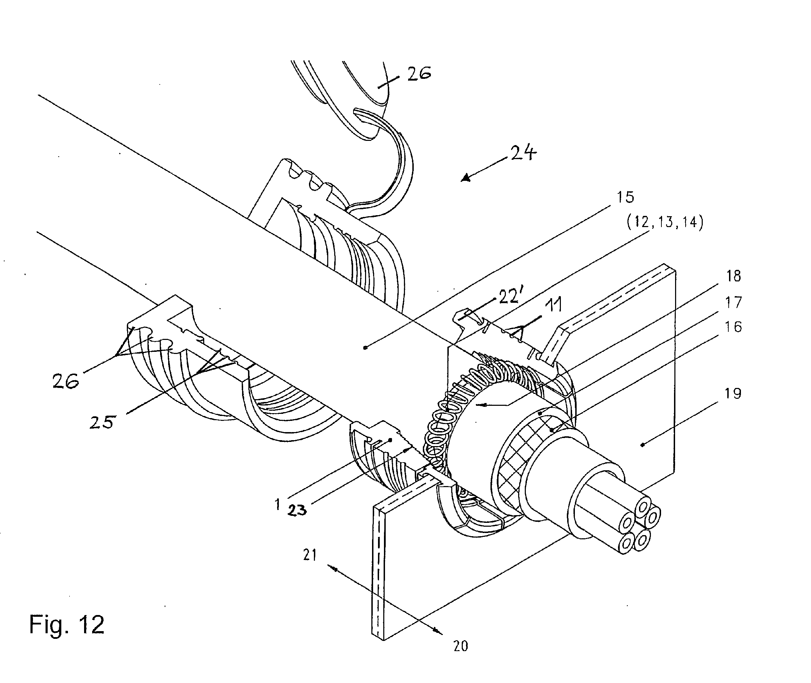

**Figur 12** zeigt eine weitere Ausführungsform der erfindungsgemässen Anordnung in derselben Ansicht wie Fig. 10. Im Unterschied zur Ausführungsform von Fig. 10 ist die Innenfläche 23 der Hülse 1 konisch geformt, bspw. gegen den Aussenhalbraum 21 hin sich verengend, und vorzugsweise mit einer Feinabstufung versehen. Die Feder 12 wird, wie anlässlich von Fig. 8 beschrieben, mittels Ausüben einer Zugkraft vom Aussenhalbraum 21 her und/oder einer Stosskraft vom Innenhalbraum 20 her auf das Kabel 15 in die sich konisch verengende Hülse 1 eingeführt. Dabei rastet sie rätschenartig in den Stufen der Feinabstufüng ein. Sie rutscht so weit in die Hülse 1 hinein, bis die ausgeübte Kraft nicht mehr ausreicht, um sie noch flacher zu legen. In dieser eingerasteten Position wird sie durch Formschluss und durch Reibungskräfte festgehalten. Die Feinabstufung der Hülseninnenfläche 23 begünstigt das Verharren der Feder 12 in dieser Position. Die in Fig. 12 dargestellte Hülse 1 kann vorzugsweise mittels Kunststoffspritztechnik hergestellt werden, weil ihre Innenfläche hinterschneidungsfrei ist. Die Ausführungsform von Fig. 12 lässt eine praktisch stufenlose Fixierung und Kontaktierung des Kabels 15 zu.

In Figur 12 ist ausserdem eine Abdichthaube 24 eingezeichnet. Diese hat zur Aufgabe, die Haltevorrichtung gegen Staub und Feuchtigkeit abzudichten. Bei entsprechender Materialwahl kann die Abdichthaube 24 auch eine EMV-Abdichtung gewährleisten. Sie ist über die Hülse 1 stülpbar, derart, dass Schnappteil 28 mittels Schnappnase 6' und Ringnute 8' des Schnappverschlusses 22' an der Hülse 1, der nicht für eine Verbindung mit der Wandung 19 verwendet wird, mit der Hülse verbunden ist. Ein Einrasten von Rippen 25 auf der Innenseite der Abdichthaube 24 in die Rillen 11 auf der Aussenseite der Hülse 1 gewährleistet eine optimale Abdichtung, insbesondere gegen ein Eindringen von Feuchtigkeit in den Innenhalbraum 20. Auch die Abdichthaube 24 kann werkzeugfrei demontiert werden, indem von aussen ein radialer Druck auf an der Aussenfläche der Abdichthaube 24 angebrachte Griffrillen 26 ausgeübt wird, wodurch das Schnappteil 28 aus der Schnappnase 6' und Ringnute 8' gelöst wird. Die Abdichthaube 24 ist durch eine vorzugsweise mit ihr verbundene (nur teilweise eingezeichnete) Verschlusskappe 27 verschliessbar, wenn die Hülse 1 nicht mit einem Kabel 15 bestückt ist. Selbstverständlich kann die Abdichthaube 24 auch in Kombination mit anderen Ausführungsformen der Erfindung eingesetzt werden.

In **Figur 13** ist eine andere Ausführungsform einer erfindungsgemässen Haltevorrichtung dargestellt. In dieser Ausführungsform sind die Durchführmittel als ein Flanschelement 31 ausgebildet, welches senkrecht zur Kabelachse steht. Das Flanschelement 31 weist mehrere Durchführöffnungen auf, durch welche jeweils ein Kabel 15 durchführbar ist. Die Innenflächen der Durchführöffnungen sind wie in der Ausführungsform von Fig. 12 konisch geformt und mit einer Feinabstufung versehen. Das Flanschelement 31 kann aus Metall oder Kunststoff, versehen mit einem elektrisch leitenden Zusatz, hergestellt sein. Die Herstellung kann bspw. mittels Kunststoffspritztechnik erfolgen, oder die Durchführöffnungen können herausgeformt werden. Der Aufbau der Haltevorrichtung erfolgt wie oben beschrieben.

Das in Fig. 13 dargestellte Flanschelement 31 kann einzeln, vorzugsweise aber in Kombination mit einer in der Schrift DE-197'31'448 beschriebenen Befestigungsvorrichtung 30 eingesetzt werden. Die Geometrien des Flanschelementes 31 und der Befestigungsvorrichtung 30 werden zu diesem Zweck aufeinander abgestimmt, insbesondere die Positionen der Durchführöffnungen für die Kabel 15, die Positionen von Durchgangslöchern 32 für die Befestigung, Rillen 33 für Dichtmittel zwischen Flanschelement 31 und Befestigungsvorrichtung 30, die äusseren Abmessungen etc. Flanschelement 31 und Befestigungsvorrichtung 30 werden zusammengefügt und aneinander und vorzugsweise an einem Flanschgehäuse befestigt, bspw. mittels Schrauben in Durchgangslöchern 32. In der Ausführungsform von Fig. 13 ist die Befestigungsvorrichtung 30 dem Aussenhalbraum 21 und das Flanschelement 31 dem Innenhalbraum 20 zugewandt. Dies könnte auch umgekehrt sein. Zwischen Flanschelement 31 und Befestigungsvorrichtung 30 kann auch die Wandung verlaufen.

Nach dem Zusammenfügen von Flanschelement 31 und Befestigungsvorrichtung 30 wird die Haltevorrichtung aufgebaut, indem jeweils ein Kabel vom Aussenhalbraum 21 her durch die in der Befestigungsvorrichtung 30 befindliche Zwischenplatte 34 gestossen wird und danach wie oben beschrieben vorgegangen wird. Ein Anschlag 35 in jeder Durchführöffnung stellt jeweils sicher, dass die Feder nicht zwischen Flanschelement 31 und Befestigungsvorrichtung 30 rutschen kann. Die Befestigungsvorrichtung 30 gewährleistet eine Zugentlastung und eine Abdichtung gegen Feuchtigkeit und Staub.

**Figur 14** zeigt eine weitere Ausführungsform einer erfindungsgemässen Haltevorrichtung mit mehreren Durchführöffnungen, vorzugsweise in Kombination mit einer in der Schrift DE-197'31'448 beschriebenen Befestigungsvorrichtung 30. In dieser Ausführungsform sind die Durchführöffnungen der Haltevorrichtungen analog zu derjenigen der Fig. 1-9 gestaltet, d. h. mit mindestens einer Nut 3, 4 versehen. Die Nuten 3, 4 sind ohne übermässigen Aufwand herstellbar, indem das Flanschelement 36 als Stapel aus mehreren Flanschplatten 37-39 aufgebaut ist. Die Durchführöffnungen in den Flanschplatten 37-39 für die Durchführung der Kabel 15 können hinterschneidungsfrei gestaltet werden, so dass die Flanschplatten 37-39 auf einfache und kostengünstige Weise in Kunststoffspritztechnik hergestellt werden können; die Nuten 3, 4 werden durch Stapelung der Flanschplatten 37-39 gebildet. Alternativ können die Flanschplatten 37-39 auch aus Metall hergestellt sein. Aufbau und Funktionsweise der Haltevorrichtung wurden bereits weiter oben beschrieben.

Die Haltevorrichtungen von Fig. 13 oder 14 können Bestandteil eines Flanschgehäuses sein. Sie können auch an einer Wandung, bspw. von Anschlussdosen, Kanal- oder Steuerungssystemen, befestigt oder darin integriert sein.

## Patentansprüche

1. Haltevorrichtung zur befestigten, zugentlasteten und elektromagnetisch abgedichteten Halterung eines elektromagnetische Abschirmmittel (16) enthaltenden, eine Kabelachse definierenden Kabels (15), beinhaltend
Durchführmittel (1) mit mindestens einer Durchführöffnung zur Durchführung des Kabels (15), welche Durchführöffnung eine elektrisch leitende Innenfläche aufweist, und
in radialer Richtung bezüglich der Kabelachse elastisch verformbare Kontaktierungsmittel (12) zur Herstellung eines elektrischen Kontaktes zwischen den elektromagnetischen Abschirmmitteln (16) und der Innenfläche der Durchführmittel (1), wobei die Kontaktierungsmittel als Ringfeder (12,13, 14) ausgebildet sind,
**dadurch gekennzeichnet, dass**
die Innenfläche der mindestens einen Durchführöffnung der Durchführmittel (1, 36) mindestens eine ringförmige Nut (3,4) zur Aufnahme der Ringfeder (12) aufweist, und
die Ringfeder (12) geeignet ist, eine mechanische Einrastverbindung zwischen dem Kabel (15) und den Durchführmitteln (1) beim Bewegen des Kabels mitsamt der Ringfeder in Richtung der Kabelachse relativ zu den Durchführmitteln (1) werkzeugfrei herzustellen.

2. Haltevorrichtung nach Anspruch 1, wobei die Innenfläche der Durchführmittel (1, 36) mehrere ringförmige Nuten (3,4) mit unterschiedlichen Tiefen, zur Aufnahme der Ringfeder (12) aufweist.

3. Haltevorrichtung nach Anspruch 1, wobei zumindest ein Teil der Innenfläche der mindestens einen Durchführöffnung der Durchführmittel (1, 31) in Richtung der Kabelachse konisch geformt ist und der konisch geformte Teil der Innenfläche mit fein geformten Abstufungen versehen ist.

4. Haltevorrichtung nach einem der vorangehenden Ansprüche, wobei die Ringfeder (12, 13, 14) vorzugsweise einen kreisförmigen, halbkreisförmigen oder elliptischen Querschnitt aufweist und welche vorzugsweise mit schräger Wicklung versehen ist.

5. Haltevorrichtung nach einem der vorangehenden Ansprüche, wobei die Durchführmittel (1) als, vorzugsweise zylindrische, Hülse ausgebildet sind, deren Aussenfläche Befestigungsmittel (22,22') für die Befestigung der Hülse (1) in einer Öffnung in einer Wandung (19) aufweist, welche Befestigungsmittel (22,22') vorzugsweise zur Bildung eines Schnapp- oder Schraubverschlusses geeignet sind.

6. Haltevorrichtung nach Anspruch 5, wobei die Aussenfläche der Hülse (1) zwei in Richtung der Kabelachse voneinander beabstandete, vorzugsweise an beiden Enden der Hülse (1) angebrachte, Befestigungsmittel (22,22') aufweist.

7. Haltevorrichtung nach Anspruch 6, wobei an mindestens einem (22') der zwei Befestigungsmittel (22,22') eine Abdichthaube (24) zur Abdichtung der Haltevorrichtung gegen Schmutz, Feuchtigkeit und/oder zur EMV-Abdichtung befestigbar ist, welche Abdichtungshaube (24) vorzugsweise mit einer Verschlusskappe (26) zum Verschliessen der Durchführöffnung ausgestattet ist.

8. Haltevorrichtung nach einem der Ansprüche 5-7, wobei die Innenfläche der Hülse (1) einen sich in Richtung der Kabelachse von aussen nach innen verengenden Aufnahmekragen (2) zum Einführen der Ringfeder (12) aufweist.

9. Haltevorrichtung nach einem der Ansprüche 1-4, wobei die Durchführmittel als senkrecht zur Kabelachse stehendes Flanschelement (31,36) ausgebildet sind, welches Flanschelement (31,36) vorzugsweise mehrere Durchfuhröffnungen beinhaltet.

10. Haltevorrichtung nach Anspruch 9, wobei das Flanschelement (36) als Stapel von mehreren, vorzugsweise in einem Flanschgehäuse eingebetteten Flanschplatten (37-39) aufgebaut ist.

11. Haltevorrichtung nach einem der vorangehenden Ansprüche, wobei die Formung der Durchführmittel (1, 31,36,37-39) so ausgelegt ist, dass die Durchführmittel (1, 31,36, 37-39) hinterschneidungsfrei herstellbar sind.

12. Haltevorrichtung nach einem der vorangehenden Ansprüche, wobei die Durchführmittel aus Metall oder aus mit elektrisch leitfähigem Material durchsetztem Kunststoff hergestellt sind.

13. Anordnung einer Haltevorrichtung nach einem der vorangehenden Ansprüche und mindestens eines in der Haltevorrichtung gehaltenen Kabels (15), welches Kabel (15) einen elektrisch isolierenden Mantel (17) aufweist, wobei im Bereich der Haltevorrichtung (1) eine bis zu den elektromagnetischen Abschirmmitteln (16) reichende ringförmige Nut (18) aus dem Mantel (17) herausgeformt ist und die Ringfeder (12) mit der Nut (18) zusammenwirkt, um die mechanische Einrastverbindung zwischen dem Kabel (15) und den Durchführmitteln(1) herzustellen.

14. Verfahren zum Aufbau einer Anordnung nach Anspruch 13, **gekennzeichnet durch** die folgenden Verfahrensschritte:
(a) Herausformen einer bis zu den elektromagnetischen Abschirmmitteln (16) reichenden ringförmigen Nut (18) aus dem Mantel (17) des Kabels (15);
(b) Durchführen des Kabels (15) **durch** die Durchführöffnung der Durchführmittel (1);
(c) Aufbringen der Ringfeder (12) auf die ringförmige Nut des Kabels (15), derart, dass die Ringfeder (12) mit den elektromagnetischen Abschirmmitteln (16) des Kabels (15) elektrisch kontaktiert ist;
(d) Herstellen eines elektrischen Kontaktes zwischen den elektromagnetischen Abschirmmitteln (16) und den Durchführmitteln (1) sowie einer mechanischen Einrastverbindung zwischen dem Kabel (15) und den Durchführmitteln mittels der Ringfeder (12), indem das Kabel (15) relativ zu den Durchführmitteln(1) in Richtung der Kabelachse bewegt wird.

15. Verfahren nach Anspruch 14, wobei in Verfahrensschritt (d) das Kabel (15) zusammen mit der Ringfeder (12) so lange relativ zu und in den Durchführmitteln (1) in Richtung der Kabelachse bewegt wird, bis eine mechanische Einrastverbindung zwischen dem Kabel (15) und den Durchführmitteln (1) zustande kommt.

16. Verfahren zum Demontieren einer Anordnung nach Anspruch 13, **gekennzeichnet durch** die folgenden Verfahrensschritte:
(a) Lösen der mechanischen Einrastverbindung, indem eine Mehrkraft in Richtung der Kabelachse auf das Kabel (15) ausgeübt wird;
(b) Bewegen des Kabels relativ zu den Durchführmitteln (1) in Richtung der Kabelachse, bis sich die Ringfeder (12) ausserhalb der Durchführmittel (1) befindet;
(c) Entfernen der Ringfeder (12) von der ringförmigen Nut (18);
(d) Entfernen des Kabels (15) von den Durchführmitteln (1).

## Claims

1. Holding apparatus for fixedly holding, with strain relief and electromagnetic sealing, a cable (15), which contains electromagnetic screening means (16) and defines a cable axis, containing
lead-through means (1) having at least one lead-through opening for leading through the cable (15), which lead-through opening has an electrically conductive inner face, and
contact-making means (12), which are elastically deformable in the radial direction with respect to the cable axis, for producing an electrical contact between the electromagnetic screening means (16) and the inner face of the lead-through means (1), the contact-making means being in the form of annular springs (12, 13, 14),
**characterized in that**
the inner face of the at least one lead-through opening of the lead-through means (1, 36) has at least one annular groove (3, 4) for accommodating the annular spring (12), and
the annular spring (12) is suitable for producing a mechanical latch-in connection between the cable (15) and the lead-through means (1), without the use of a tool, when moving the cable together with the annular spring in the direction of the cable axis in relation to the lead-through means (1).

2. Holding apparatus according to Claim 1, the inner face of the lead-through means (1, 36) having a plurality of annular grooves (3, 4) having different depths, for the purpose of accommodating the annular spring (12).

3. Holding apparatus according to Claim 1, at least part of the inner face of the at least one lead-through opening of the lead-through means (1, 31) being shaped conically in the direction of the cable axis, and the conically shaped part of the inner face being provided with fine graduations.

4. Holding apparatus according to one of the preceding claims, the annular spring (12, 13, 14) preferably having a circular, semicircular or elliptical cross section and preferably being provided with skewed winding.

5. Holding apparatus according to one of the preceding claims, the lead-through means (1) being in the form of a, preferably cylindrical, sleeve, whose outer face has fixing means (22, 22') for fixing the sleeve (1) in an opening in a wall (19), which fixing means (22, 22') are preferably suitable for forming a snap-action or screw-type closure.

6. Holding apparatus according to Claim 5, the outer face of the sleeve (1) having two fixing means (22, 22'), which are spaced apart from one another in the direction of the cable axis and are preferably fitted to both ends of the sleeve (1).

7. Holding apparatus according to Claim 6, it being possible for a sealing hood (24) for sealing the holding apparatus against dirt, moisture and/or for EMC sealing to be fixed to at least one (22') of the two fixing means (22, 22'), which sealing hood (24) is preferably equipped with a closure cap (26) for closing the lead-through opening.

8. Holding apparatus according to one of Claims 5-7, the inner face of the sleeve (1) having an accommodating collar (2), which tapers from the outside inwards in the direction of the cable axis, for inserting the annular spring (12).

9. Holding apparatus according to one of Claims 1-4, the lead-through means being in the form of a flange element (31, 36) which is at right angles to the cable axis, which flange element (31, 36) preferably contains a plurality of lead-through openings.

10. Holding apparatus according to Claim 9, the flange element (36) being in the form of a stack of a plurality of flange plates (37-39), which are preferably embedded in a flange housing.

11. Holding apparatus according to one of the preceding claims, the shape of the lead-through means (1, 31, 36, 37-39) being designed such that the lead-through means (1, 31, 36, 37-39) can be produced without an undercut.

12. Holding apparatus according to one of the preceding claims, the lead-through means being produced from metal or from plastic permeated with electrically conductive material.

13. Arrangement of a holding apparatus according to one of the preceding claims and at least one cable (15) held in the holding apparatus, which cable (15) has an electrically insulating sheath (17), an annular groove (18), which reaches as far as the electromagnetic screening means (16), being shaped out of the sheath (17) in the region of the holding apparatus (1), and the annular spring (12) interacting with the groove (18) in order to produce the mechanical latch-in connection between the cable (15) and the lead-through means (1).

14. Method for constructing an arrangement according to Claim 13, **characterized by** the following method steps:
(a) shaping an annular groove (18), which reaches as far as the electromagnetic screening means (16), out of the sheath (17) of the cable (15);
(b) leading the cable (15) through the lead-through opening of the lead-through means (1);
(c) attaching the annular spring (12) to the annular groove of the cable (15) in such a way that the annular spring (12) makes electrical contact with the electromagnetic screening means (16) of the cable (15);
(d) producing an electrical contact between the electromagnetic screening means (16) and the lead-through means (1) and a mechanical latch-in connection between the cable (15) and the lead-through means by means of the annular spring (12) by the cable (15) being moved in relation to the lead-through means (1) in the direction of the cable axis.

15. Method according to Claim 14, in method step (d) the cable (15) being moved together with the annular spring (12) in relation to and in the lead-through means (1) in the direction of the cable axis until a mechanical latch-in connection is brought about between the cable (15) and the lead-through means (1).

16. Method for dismantling an arrangement according to Claim 13, **characterized by** the following method steps:
(a) detaching the mechanical latch-in connection by extra force being exerted on the cable (15) in the direction of the cable axis;
(b) moving the cable in relation to the lead-through means (1) in the direction of the cable axis until the annular spring (12) is located outside of the lead-through means (1);
(c) removing the annular spring (12) from the annular groove (18);
(d) removing the cable (15) from the lead-through means (1).

## Revendications

1. Dispositif de maintien pour la rétention fixée, en décharge de traction et étanche du point de vue électromagnétique d'un câble (15) contenant des moyens de protection électromagnétique (16) et définissant un axe de câble, comprenant
des moyens de traversée (1) avec au moins une ouverture de passage pour le passage du câble (15), laquelle ouverture de passage possède une surface intérieure conductrice d'électricité, et
des moyens de contact (12) déformables de manière élastique dans le sens radial par rapport à l'axe du câble pour établir un contact électrique entre les moyens de protection électromagnétique (16) et la surface intérieure des moyens de traversée (1), lesquels moyens de contact sont conformés comme des ressorts annulaires (12, 13, 14),
**caractérisé en ce que**
la surface intérieure de l'ouverture de passage au nombre d'une au moins des moyens de traversée (1, 36) possède au moins une gorge annulaire (3, 4) destinée à recevoir les ressorts annulaires (12), et
le ressort annulaire (12) est apte à établir sans l'aide d'outils un assemblage par emboîtement mécanique entre le câble (15) et les moyens de traversée (1) lorsque le câble est déplacé avec le ressort annulaire dans le sens de l'axe du câble par rapport aux moyens de traversée (1).

2. Dispositif de maintien selon la revendication 1, dans lequel la surface intérieure des moyens de traversée (1, 36) présente plusieurs gorges annulaires (3, 4) de différentes profondeurs pour recevoir les ressorts annulaires (12).

3. Dispositif de maintien selon la revendication 1, dans lequel une partie au moins de la surface intérieure de l'ouverture au nombre d'une au moins des moyens de traversée (1, 31) a une forme conique dans la direction de l'axe du câble et la partie de forme conique de la surface intérieure est dotée de gradins finement formés.

4. Dispositif de maintien selon l'une des revendications précédentes, dans lequel le ressort annulaire (12, 13, 14) a de préférence une section circulaire, semi-circulaire ou elliptique et possède de préférence un enroulement oblique.

5. Dispositif de maintien selon l'une des revendications précédentes, dans lequel les moyens de traversée (1) sont conçus comme une douille, de préférence cylindrique, dont la surface extérieure porte des moyens de fixation (22, 22') pour la fixation de la douille (1) dans une ouverture d'une paroi (19), lesquels moyens de fixation (22, 22') conviennent de préférence pour former un assemblage emboîté ou vissé.

6. Dispositif de maintien selon la revendication 5, dans lequel la surface extérieure de la douille (1) présente deux moyens de fixation (22, 22') distants l'un de l'autre dans le sens de l'axe du câble et disposés de préférence aux deux extrémités de la douille (1).

7. Dispositif de maintien selon la revendication 6, dans lequel peut être fixé sur au moins un (22') des deux moyens de fixation (22, 22') un capuchon d'étanchéité (24) destiné à rendre le dispositif de maintien étanche aux particules, à l'humidité et/ou aux interférences électromagnétiques, lequel capuchon d'étanchéité (24) est de préférence équipé d'un bouchon d'obturation (26) pour fermer l'ouverture de passage.

8. Dispositif de maintien selon l'une des revendications 5 à 7, dans lequel la surface intérieure de la douille (1) présente un collet de réception (2) qui se resserre de l'extérieur vers l'intérieur dans le sens de l'axe du câble pour l'insertion du ressort annulaire (12).

9. Dispositif de maintien selon l'une des revendications 1 à 4, dans lequel les moyens de traversée sont conformés comme un élément de bride (31, 36) perpendiculaire à l'axe du câble, lequel élément de bride (31, 36) présente de préférence plusieurs ouvertures de passage.

10. Dispositif de maintien selon la revendication 9, dans lequel l'élément de bride (36) est construit comme une pile de plusieurs plaques de bride (37-39) de préférence incluses dans un logement de bride.

11. Dispositif de maintien selon l'une des revendications précédentes, dans lequel la conformation des moyens de traversée (1, 31, 36, 37-39) est telle que les moyens de traversée (1, 31, 36, 37-39) peuvent être fabriqués sans contre-dépouilles.

12. Dispositif de maintien selon l'une des revendications précédentes, dans lequel les moyens de traversée sont fabriqués en métal ou en matière plastique contenant un matériau conducteur d'électricité.

13. Agencement d'un dispositif de maintien selon l'une des revendications précédentes et d'au moins un câble (15) retenu dans le dispositif de maintien, lequel câble (15) présente une enveloppe (17) isolante électrique, dans laquelle, au niveau du dispositif de maintien (1), une gorge annulaire (18) allant jusqu'aux moyens de protection électromagnétique (16) est formée dans l'enveloppe (17) et le ressort annulaire (12) coopère avec la gorge (18) pour créer l'assemblage par emboîtement mécanique entre le câble (15) et les moyens de traversée (1).

14. Procédé de construction d'un agencement selon la revendication 13, **caractérisé en ce qu'**il comporte les étapes suivantes :
(a) formation d'une gorge annulaire (18) allant jusqu'aux moyens de protection électromagnétique (16) dans l'enveloppe (17) du câble (15) ;
(b) passage du câble (15) à travers l'ouverture de passage des moyens de traversée (1) ;
(c)pose du ressort annulaire (12) sur la gorge annulaire du câble (15), de telle manière que le ressort annulaire (12) soit mis en contact électrique avec les moyens de protection électromagnétique (16) du câble ;
(d) établissement d'un contact électrique entre les moyens de protection électromagnétique (16) et les moyens de traversée (1) ainsi que d'un assemblage par emboîtement mécanique entre le câble (15) et les moyens de traversée au moyen du ressort annulaire (12), en déplaçant le câble (15) par rapport aux moyens de traversée (1) dans la direction de l'axe du câble.

15. Procédé selon la revendication 14, dans lequel, dans l'étape (d) du procédé, le câble (15) est déplacé avec le ressort annulaire (12) vers et dans les moyens de traversée (1) dans la direction de l'axe du câble jusqu'à ce qu'un assemblage par emboîtement mécanique se crée entre le câble (15) et les moyens de traversée (1).

16. Procédé pour le démontage d'un agencement selon la revendication 13, **caractérisé en ce qu'**il comporte les étapes de procédé suivantes :
(a) démontage de l'assemblage par emboîtement mécanique en exerçant une force accrue sur le câble (15) dans la direction de l'axe du câble ;
(b) déplacement du câble par rapport aux moyens de traversée (1) dans la direction de l'axe du câble, jusqu'à ce que le ressort annulaire (12) se trouve hors des moyens de traversée (1) ;
(c)retrait du ressort annulaire (12) de la gorge annulaire (18) ;
(d) retrait du câble (15) des moyens de traversée (1).
